# EUROPEAN PATENT SPECIFICATION

(11) **EP 2 416 458 B1**
(45) Date of publication and mention of the grant of the patent: **26.09.2018**
(21) Application number: 10758683.6
(22) Date of filing: 30.03.2010
(51) Int. Cl.: H01S 5/022, G02B 6/42, H01L 31/02

(54) **OPTICAL COMMUNICATION MODULE**
OPTISCHES KOMMUNIKATIONSMODUL
MODULE DE COMMUNICATION OPTIQUE

(30) Priority: 30.03.2009 JP 2009082468
(43) Date of publication of application: 08.02.2012
(73) Proprietor: AutoNetworks Technologies, Ltd., Yokkaichi-shi, Mie 510-8503 (JP); Sumitomo Wiring Systems, Ltd., Yokkaichi-shi, Mie 510-8503 (JP); Sumitomo Electric Industries, Ltd., Chuo-ku Osaka-shi Osaka 541-0041 (JP)
(72) Inventor: HAYASHI, Shigeo, Yokkaichi-shi Mie 510-8503 (JP)
(74) Representative: Winter, Brandl, Fürniss, Hübner, Röss, Kaiser, Polte - Partnerschaft mbB
(86) International application number: PCT/JP2010/055630
(87) International publication number: WO 2010/113912

(56) References cited:
- JP-A- 10 041 540
- JP-A- 10 041 540
- JP-A- 10 056 209
- JP-A- 2000 114 588
- JP-A- 2000 114 588
- JP-A- 2001 147 349
- JP-A- 2001 242 348
- JP-A- 2002 280 599
- JP-A- 2002 280 599
- JP-A- 2003 131 085
- JP-A- 2005 057 310
- JP-A- 2007 200 763
- US-A1- 2007 166 050

## Description

The present invention relates to an optical communication module incorporating a plurality of photoelectric devices for carrying out optical communication, such as a laser diode and/or a photodiode, in a package.

Conventionally, optical communication using optical fibers or the like has been wide spread. Optical communication is carried out by converting an electric signal into an optical signal using a photoelectric device, such as a laser diode, by transmitting/receiving the optical signal via an optical fiber and by converting the received optical signal into an electric signal using a photoelectric device, such as a photodiode. Hence, an optical communication module in which photoelectric devices, such as a laser diode and/or a photodiode, are contained in a single package in some cases together with peripheral circuit devices for operating the photoelectric devices has been used widely. This optical communication module is referred to as an OSA (Optical Sub-Assembly). In recent years, various inventions relating to optical communication and optical communication modules have been developed.

For example, in Patent document 1 (Japanese Patent Application Laid-Open No. 2006-40976), a photodetector is proposed in which the output of a light-receiving first photodiode and the output of a light-shielded second photodiode are respectively inputted to a differential amplifier via a gain adjusting amplifier and a low-pass filter is disposed between the output terminal of an optical power detection section for detecting optical power and the gain adjusting terminal of the gain adjusting amplifier, thereby being applicable to communication requiring high speed and a wide dynamic range.

Furthermore, in Patent document 2 (International Publication WO 01/015348), a light-receiving apparatus is proposed in which a signal-receiving photodiode, an optical level detecting photodiode, a signal amplification section for amplifying a received signal and a bias current control section for controlling a bias current supplied to this signal amplification section are formed on a single circuit board and the bias current control section operates the signal amplification section in the case that the signal current outputted from the optical level detecting photodiode has reached a predetermined reference value or more, whereby the magnitudes of the operating current and voltage can be controlled to necessary values and power consumption can be reduced. Moreover, in this light-receiving apparatus, the signal-receiving photodiode has a nearly oval photosensitive area smaller than the spread area of signal light, and the optical level detecting photodiode has a photosensitive area surrounding the photosensitive area of the signal-receiving photodiode, whereby signal light can be detected efficiently and reception capability can be improved.

The inventions according to Patent documents 1 and 2 described above relate to the peripheral circuits of photoelectric devices and are intended to enhance the communication capability for optical communication by improving the peripheral circuits. In the inventions according to Patent documents 1 and 2, an optical communication module is used in which a circuit board on which the photoelectric devices and the peripheral circuits are mounted is secured to a lead frame and sealed using a transparent resin to form a molded section and a hemispherical lens section is provided on the surface of the molded section. In this optical communication module, the lens section is disposed so as to be opposed to the output end of an optical fiber.

Moreover, in Patent document 3 (Japanese Patent Application Laid-Open No. 2005-167189), a photoelectric conversion module is proposed which is equipped with a photoelectric device for transmitting or receiving optical signals, a stem for securing the photoelectric device, a cap for covering the photoelectric device and a plurality of leads for applying electric signals to the photoelectric device or transmitting electric signals from the photoelectric device and in which a flat section is provided at one end of a predetermined lead positioned inside a package formed of the stem and the cap and an electric circuit component, one terminal of which is connected to the photoelectric device and the other terminal of which is connected to the lead, is provided on the flat section, whereby the module is excellent in high frequency property and can be made compact.

In Patent document 4 (U.S. Patent No. 7455463), an optical device module is proposed which is equipped with a first package having a first face provided with openings for accommodating a light source and/or a photodetector and for allowing optical signals to pass through and a second face on the opposite side thereof; a second package provided with an opening for accommodating an insert such as a circuit board or the like and provided so as to be perpendicular to the second face of the first package; and a lead frame for mechanically connecting the first package to the second package and for electrically connecting the light source and/or the photodetector of the first package to contacts exposed inside the opening of the second package, and in which the insert, such as a circuit board, is mechanically connected to the second package and electrically connected to the contents inside the opening, whereby the circuit devices mounted on the circuit board or the like can operate the light source and/or the photodetector. Furthermore, in this device module, a lens block on which a lens is held is secured to the first package, and an optical fiber is fitted in the opening formed in the lens block.

In Patent document 5 (U.S. Patent No. 7370414), a method for producing a lead frame connector for connecting an optical sub-assembly to the PCB (Printed Circuit Board) of an optical communication module is proposed. In this method, the shape of a conductive section is impressed on a conductive ribbon, this conductive section is bent as necessary, and a case for insulating the conductive section is formed through an injection molding process by an open reel system, and then the conductive ribbon is cut to form a single lead frame connector.

A plurality of the conductive sections contained in the single case are punched at their connection portions through a hole formed in the case, thereby being capable of being separated electrically.

In order to carry out two-way communication, an optical communication apparatus is required to be equipped with photoelectric devices, for example, a light-receiving device, such as a photodiode, and a light-emitting device, such as a laser diode. Hence, an optical communication module is required which is equipped with both the photoelectric devices, i.e., a light-receiving device and a light-emitting device, and is capable of carrying out the transmission/reception of optical signals. The optical communication apparatus can be made compact by using this kind of optical communication module.

The inventions according to Patent documents 1 and 2 relate to apparatuses incorporating a photodiode as a photoelectric device and used for reception, does not refer to any optical communication modules for transmitting optical signals and does not refer to any configurations in which a plurality of photoelectric devices are mounted. Furthermore, the invention according to Patent document 3 relates to a configuration in which a single photoelectric device is provided to carry out transmission or reception and does not refer to any configurations in which a plurality of photoelectric devices are mounted.

The optical device module according to Patent document 4 has a configuration in which both the photoelectric devices, i.e., the light source and the photodetector, are mounted in the first package, whereby the transmission and reception of optical signals can be carried out. However, the optical device module according to Patent document 4 has a configuration in which the light source and the photodetector are respectively disposed inside the two openings formed in the first package, and the light source and the photodetector carry out the transmission and reception of optical signals through two lenses provided on the lens block secured to the first package, whereby it is not easy to narrow the distance between the two photoelectric devices and it is not easy to narrow the distance between the two lenses of the lens block. Hence, the optical device module according to Patent document 4 has a disadvantage that it is not easy to be made compact.

The lead frame connector according to Patent document 5 is used to connect one photoelectric device to a circuit board. Hence, in order that an optical communication apparatus is equipped with both the photoelectric devices, i.e., a light-receiving device and a light-emitting device, the photoelectric devices are required to be connected to the circuit board using the two lead frame connectors; hence, it is not easy to make the optical communication apparatus compact.

An optical communication module according to the preamble of claim 1 is disclosed in JP 2002 280599 A. For a better understanding of the present invention, it is further referred to US 2007/166050 A1, JP 2000 114588 A, and JP 10 041540 A.

In view of the above-mentioned circumstances, it is an object of the present invention is intended to provide an optical communication module capable of being made compact by narrowing the distance between photoelectric devices and the distance between lenses even if it is equipped with a plurality of photoelectric devices.

This object is solved by the features of claim 1. Advantageous modifications are defined in the dependent claims.

In the present invention, the optical communication module is equipped with the light-emitting device for converting an electric signal into an optical signal and for transmitting the optical signal and the light-receiving device for receiving an optical signal and for converting the optical signal into an electric signal, and the light-emitting device and the light-receiving device are held on the holding section side by side (that is, so that the optical axis of the light-emitting device is nearly parallel with the optical axis of the light-receiving device).

Furthermore, the optical communication module is equipped with the transmitting lens face for condensing the light from the light-emitting device to an optical fiber or the like and the receiving lens face for condensing the light from an optical fiber or the like to the light-receiving device, and the two lens faces are integrally provided side by side on the translucent base section. At this time, the transmitting lens face is provided at the protruded end of the pillar section protruded from the base section so as to be more protruded from the base section than the receiving lens face. The base section, the pillar section, the transmitting lens face and the receiving lens face are integrally molded using a material, such as a translucent synthetic resin or glass. In the case that a plurality of lenses are molded separately, lens tubes for holding the respective lenses are required; however, the distance between the lens faces can be narrowed by integrally molding the plurality of lens faces.

With this configuration, the distance to the photoelectric area (the light-emitting area of the light-emitting device or the light-receiving area of the light-receiving device) of the photoelectric device is longer in the transmitting lens face provided on the pillar section protruded from the base section than in the receiving lens face provided on the base section by the protruded amount of the pillar section. In the case that a transmitting optical fiber and a receiving optical fiber are disposed so that the distance from the light-emitting device to the transmitting optical fiber is nearly equal to the distance from the light-receiving device to the outgoing end of the receiving optical fiber, the distance from the transmitting lens face to the transmitting optical fiber is shorter than the distance from the receiving lens face to the receiving optical fiber.

The light emitted from the light-emitting device reaches the transmitting lens face through the base section and the pillar section; in the case that a part of the light is spread outward from the transmitting lens face and reaches the peripheral face of the pillar section at this time, the light is reflected by the peripheral face of the pillar section and reaches the transmitting lens face. The light having reached the transmitting lens face is condensed to the transmitting optical fiber. Hence, the light from the light-emitting device is not incident on the receiving lens face and is not received by the light-receiving device.

Furthermore, the light outputted from the receiving optical fiber is condensed to the light-receiving device by the receiving lens face. In the case that a part of the light from the receiving optical fiber is spread outward from the receiving lens face and reaches the peripheral face of the pillar section at this time, the light is reflected by the peripheral face of the pillar section and reaches the receiving lens face. Hence, the light outputted from the receiving optical fiber is not incident on the transmitting lens face from the pillar section and is not condensed to the transmitting optical fiber.

Hence, the distance between the two lens faces provided side by side and the distance between the two photoelectric devices provided side by side can be narrowed while optical signals relating to the plurality of photoelectric devices are prevented from being transmitted or received improperly, whereby the optical communication module according to the present invention can be made compact.

In addition, the side face of the pillar section on which the transmitting lens face is provided, located on the side of the receiving lens face, is formed into a flat face. Hence, the light outputted from the receiving optical fiber to the outside of the receiving lens face can be reflected securely to the receiving lens face by the flat face provided on the side face of the pillar section, and the light outputted from the light-emitting device is reflected securely to the transmitting lens face by the flat face of the pillar section.

Furthermore, in the present invention, the base section, the pillar section, the transmitting lens face and the receiving lens face are integrally molded with the holding section for holding the light-emitting device and the light-receiving device using a translucent synthetic resin. The light-emitting device and the light-receiving device may be sealed using a translucent synthetic resin or may be sealed by joining a cover or the like to the holding section so as to cover it. Hence, the number of components constituting the optical communication module can be reduced and the production process thereof can be made easy.

Moreover, in the present invention, the light-shielding section is provided inside the base section so that the outgoing path of the light from the light-emitting device to the transmitting lens face is shut off from the incident path of the light from the receiving lens face to the light-receiving device. Hence, improper light signal transmission and reception, such as the reception of the light emitted from the light-emitting device through the translucent base section by the light-receiving device, can be prevented securely.

Still further, in the present invention, the conductors are respectively connected to the light-emitting device and the light-receiving device to transmit and receive electric signals. These plural conductors can be held by the holding section. A part of the conductors is used as the light-shielding section, for example, by bending the conductor and by disposing the bent part between the outgoing path from the light-emitting device and the incident path to the light-receiving device. Hence, the light-shielding section can be accomplished easily without using another member.

In the case of the present invention, the transmitting lens face provided on the protruded end of the pillar section protruded from the base section and the receiving lens face provided on the base section are integrally molded with the base section and the pillar section using a translucent material; hence, the transmitting lens face and the receiving lens face being adjacent to each other can be disposed while the distance therebetween is narrowed, and the light-emitting device and the light-receiving device can be disposed while the distance therebetween is narrowed, whereby the optical communication module can be made compact and an optical communication apparatus incorporating this can be made compact.

Furthermore, the distance between the light-emitting area of the light-emitting device and the transmitting lens face is made longer than the distance between the light-receiving area of the light-receiving device and the receiving lens face by the protruded amount of the pillar section; hence, improper optical signal transmission and reception can be prevented; for example, the optical signal emitted from the light-emitting device can be prevented from being received by the light-receiving device, or the optical signal to be received by the light-receiving device can be prevented from being outputted. As a result, even in the optical communication module that is made compact by narrowing the distance between the lens faces adjacent to each other and the distance between the photoelectric devices, improper optical signal transmission and reception can be prevented and accurate optical communication can be carried out.
FIG. 1 is a schematic sectional view showing a configuration of an optical communication module according to the present invention;
FIG. 2 is a schematic plan view showing the configuration of the optical communication module according to the present invention;
FIG. 3 is a schematic plan view showing the configuration of the optical communication module according to the present invention;
FIG. 4A is a schematic view showing configurations of a light receiving device and a light-emitting device provided for the optical communication module according to the present invention;
FIG. 4B is a schematic view showing configurations of the light receiving device and the light-emitting device provided for the optical communication module according to the present invention;
FIG. 4C is a schematic view showing configurations of the light receiving device and the light-emitting device provided for the optical communication module according to the present invention;
FIG. 5 is a schematic view showing a state in which an OSA is disposed so as to be opposed to two optical fibers; and
FIG. 6 is a schematic sectional view showing a configuration of an optical communication module according to a modification example of the present invention.

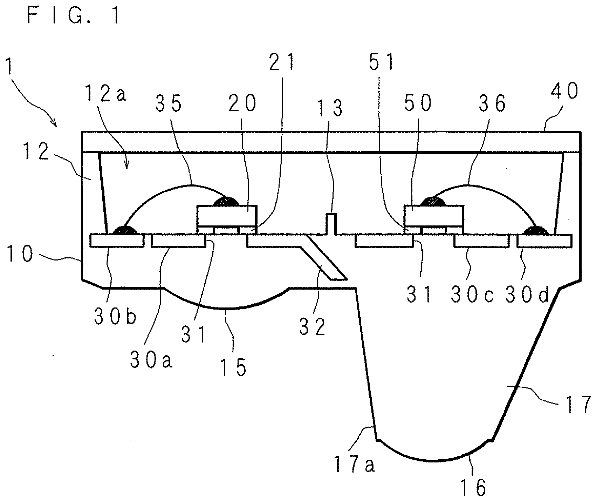

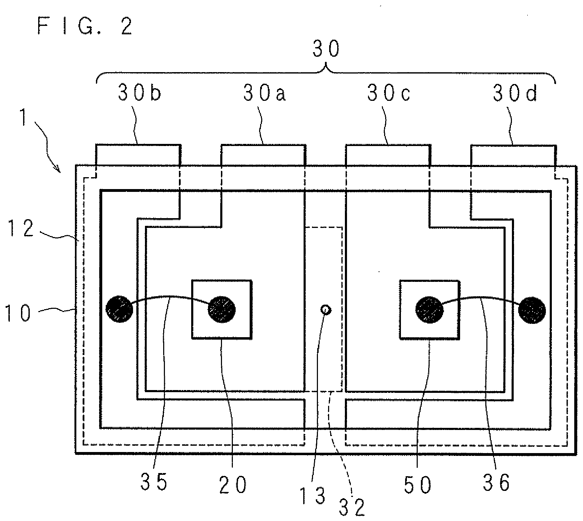

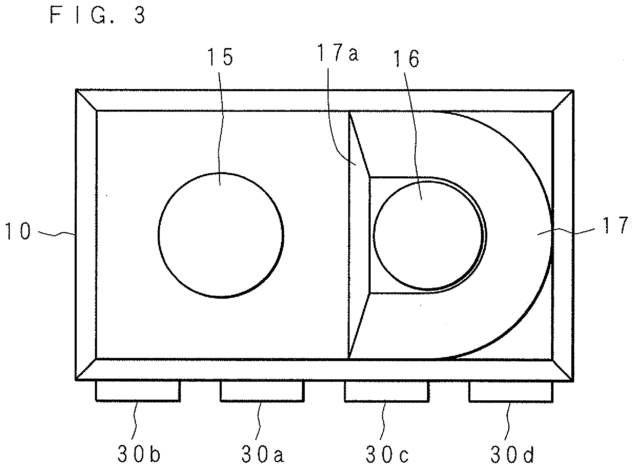

The present invention will be described below specifically on the basis of the drawings showing an embodiment thereof. FIG. 1 is a schematic sectional view showing a configuration of an optical communication module according to the present invention. FIG. 2 is a schematic plan view showing the configuration of the optical communication module according to the present invention in a state in which a cover 40 (described later) of the optical communication module is not mounted. Furthermore, FIG. 3 is a schematic plan view showing the configuration of the optical communication module according to the present invention on the side opposite to that shown in FIG. 2.

Numeral 1 in the figures designates an OSA, in which a photodiode (a light-receiving device) 20 and a laser diode (a light-emitting device) 50 are sealed and formed into a single component, corresponding to the optical communication module according to the present invention. The OSA 1 is equipped with a base (a holding section and a base section) 10 formed into a plate shape having a nearly rectangular shape in a plan view, and the base 10 is formed of a light-transmitting synthetic resin. The photodiode 20 and the laser diode 50 are connected to a one-side face (a face on the upper side in FIG. 1, hereafter simply referred to as an upper face) of the base 10, and a receiving lens face 15 and a transmitting lens face 16 are provided on the opposite side face (a face on the lower side in FIG. 1, hereafter simply referred to as a lower face). On the upper face of the base 10, a peripheral wall section 12 is provided around the peripheral portion thereof, and a concave area 12a accommodating the photodiode 20 and the laser diode 50 is formed by the upper face of the base 10 and the peripheral wall section 12.

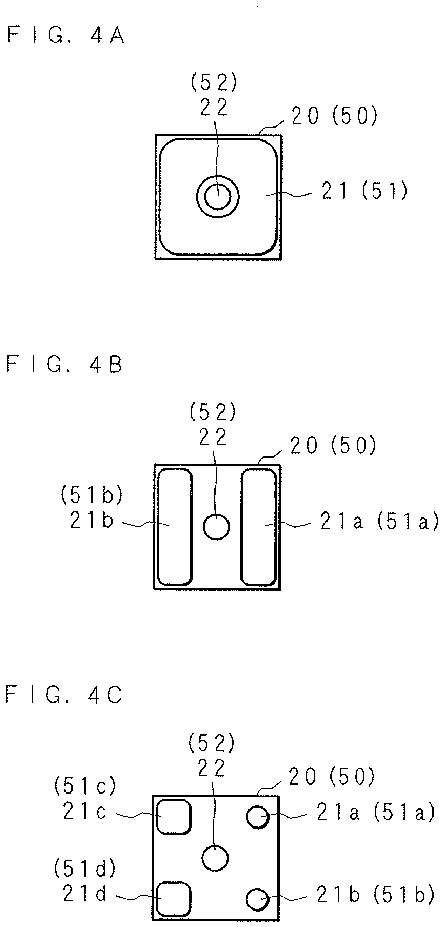

FIGS. 4A to 4C are schematic views showing the configurations of the light receiving device and the light-emitting device provided for the optical communication module according to the present invention, and three configuration examples of the photodiode 20 and the laser diode 50 on the lower face side are shown in FIGS. 4A to 4C. Since the photodiode 20 and the laser diode 50 have a nearly identical configuration, reference codes relating to the laser diode 50 are written in parentheses in FIGS. 4A to 4C.

The photodiode 20 (the laser diode 50) is formed into a plate shape having a nearly square shape in a plan view, a light-receiving section (a light-receiving area) 22 for detecting light and converting the light into an electric signal (a light-emitting section (a light-emitting area) 52 for emitting light depending on the electric signal) is provided at a nearly central area of the lower face, and one or more connection terminal sections 21 (51) are provided around the light-receiving section 22 (the light-emitting section 52). The connection terminal sections 21 (51) are terminals through which the electric signal of the photodiode 20 (the laser diode 50) is inputted and outputted and are used for connection to conductive plates 30 via solder, conductive adhesive or the like.

For example, the connection terminal section 21 (51) can be formed into a ring shape surrounding the light-receiving section 22 (the light-emitting section 52) (see FIG. 4A). In this example, although only one connection terminal section 21 (51) can be provided on the lower face of the photodiode 20 (the laser diode 50), since the photodiode 20 (the laser diode 50) requires two input/output terminals, another connection terminal section is required to be provided on the upper face or the side face thereof, for example. In the embodiment, the other connection terminal section (not shown) is provided on the upper face of the photodiode 20 (the laser diode 50), and the connection terminal section on the upper face is electrically connected to the conductive plate 30 with a wire 35 (36) made of a metal.

Furthermore, for example, two connection terminal sections 21a and 21b (51a and 51b) may be provided on the lower face of the photodiode 20 (the laser diode 50) (see FIG. 4B). In this case, the respective connection terminal sections 21a and 21b (51a and 51b) have a nearly rectangular shape and can be disposed while the light-receiving section 22 (the light-emitting section 52) is located therebetween. Moreover, for example, in addition to the two connection terminal sections 21a and 21b (51a and 51b) through which electric signals are inputted and outputted, dummy connection terminal sections 21c and 21d (51c and 51d) may be provided (see FIG. 4C) which are used only for connection via solder, conductive adhesive or the like without being used for the input and output of electric signals. In this case, the four connection terminal sections 21a to 21d (51a to 51d) can be disposed respectively at the four corners of the lower face of the photodiode 20 (the laser diode 50).

In the following descriptions and drawings, it is assumed that the OSA 1 is equipped with the photodiode 20 and the laser diode 50 shown in FIG. 4A.

Still further, the conductive plates 30 (30a to 30d) made of a metal are embedded and held inside the concave area 12a so that one face thereof is exposed. The connection terminal section 21 of the photodiode 20 and the connection terminal section 51 of the laser diode 50 are connected to the exposed portions of the conductive plates 30 inside the concave area 12a using solder, conductive adhesive or the like, and the terminals provided, for example, on the upper faces of the photodiode 20 and the laser diode 50 are connected via the wires 35 and 36. Inside the concave area 12a, the photodiode 20 and the laser diode 50 are disposed side by side in the longitudinal direction of the base 10. The conductive plates 30 are used to transmit and receive electric signals between the photodiode 20 and the laser diode 50 and the outside; in other words, the conductive plates 30 are equivalent to wires for connection to circuit components in a communication circuit in which the photodiode 20 and the laser diode 50 are used.

The OSA 1 according to the embodiment is equipped with four conductive plates 30a to 30d; the first conductive plate 30a and the second conductive plate 30b are connected to the photodiode 20, and the third conductive plate 30c and the fourth conductive plate 30d are connected to the laser diode 50. The first conductive plate 30a and the third conductive plate 30c are disposed side by side in the longitudinal direction of the base 10, each having a nearly square portion in which a nearly circular opening 31 is formed and a portion extending from this portion outward on the long side of the base 10. The diameter of the opening 31 is smaller than the length of the one side of the lower face of the photodiode 20 and the laser diode 50 and larger than the diameter of the light-receiving section 22 of the photodiode 20 and the light-emitting section 52 of the laser diode 50. The connection terminal section 21 of the photodiode 20 is connected to the peripheral portion of the opening 31 of the first conductive plate 30a via solder, conductive adhesive or the like, and the connection terminal section 51 of the laser diode 50 is connected to the peripheral portion of the opening 31 of the third conductive plate 30c via solder, conductive adhesive or the like.

Furthermore, the first conductive plate 30a has a light-shielding plate 32 provided so as to be bent from one side of the nearly square portion thereof. The light-shielding plate 32 is not exposed to the upper face of the base 10, but is disposed at a nearly central area of the base 10 so as to be bent downward from the first conductive plate 30a and embedded inside the base 10. Hence, inside the translucent base 10, the light-shielding plate 32 obstructs light from being transmitted between the side in which the photodiode 20 is provided and the opposite side in which the laser diode 50 is provided, thereby preventing improper transmission and reception of optical signals.

The second conductive plate 30b and the fourth conductive plate 30d are respectively disposed along the periphery of the base 10 so as to surround the first conductive plate 30a and the third conductive plate 30c, and one end portion of each of conductive plates 30b and 30d extends outward from a long side of the base 10. The second conductive plate 30b is connected to the terminal provided on the upper face of the photodiode 20 via the wire 35, and the fourth conductive plate 30d is connected to the terminal provided on the upper face of the laser diode 50 via the wire 36.

The end portions of the four conductive plates 30a to 30d respectively extend from the long side of the base 10, and these extension portions are used as terminals for connecting the OSA 1 to the circuit board of a communication apparatus, for example. The communication apparatus equipped with the OSA 1 can receive an optical signal by checking the voltage or current developed between the first conductive plate 30a and the second conductive plate 30b and can transmit an optical signal by applying a predetermined voltage between the third conductive plate 30c and the fourth conductive plate 30d.

Moreover, on the lower face of the base 10 of the OSA 1, the receiving lens face 15 and the transmitting lens face 16 are disposed side by side in the longitudinal direction of the base 10. The receiving lens face 15 and the transmitting lens face 16 are integrally molded with the base 10, the peripheral wall section 12, etc. using a translucent synthetic resin. The receiving lens face 15 is provided on the opposite side of the opening 31 of the first conductive plate 30a held on the upper face side of the base 10, in other words, on the lower face of the base 10, so that the center of the receiving lens face 15 is nearly aligned with the center of the opening 31 of the first conductive plate 30a. The photodiode 20 connected to the first conductive plate 30a can receive the light condensed by the receiving lens face 15 at the light-receiving section 22 through the translucent base 10 and the opening 31 of the first conductive plate 30a.

Similarly, the transmitting lens face 16 is provided on the opposite side of the opening 31 of the third conductive plate 30c held on the upper face side of the base 10, in other words, on the lower face of the base 10, so that the center of the transmitting lens face 16 is nearly aligned with the center of the opening 31 of the third conductive plate 30c. However, on the lower face of the base 10, a pillar section 17 having a nearly frusto-conical shape, part of the peripheral face of which is formed into a flat face 17a, is provided so as to be protruded downward, and the transmitting lens face 16 is provided on the protruded end face (lower end face) of this pillar section 17. The pillar section 17 is integrally molded with the base 10 and the transmitting lens face 16. The light from the light-emitting section 52 of the laser diode 50 connected to the third conductive plate 30c is outputted from the transmitting lens face 16 through the opening 31 of the third conductive plate 30c, the translucent base 10 and the pillar section 17 and condensed by a transmission optical fiber or the like. The flat face 17a of the pillar section 17 has a nearly trapezoidal shape and is formed on the peripheral face of the pillar section 17 on the side of the receiving lens face 15. The lengths of the upper bottom and the lower bottom of the flat face 17a are longer than the diameter of the receiving lens face 15.

Furthermore, a positioning section 13 having a round bar shape is protruded from a nearly central area of the upper face of the base 10 of the OSA 1 inside the concave area 12a. The positioning section 13 serves as a positioning reference when the photodiode 20 and the laser diode 50 are connected to the conductive plates 30 (30a and 30c) inside the concave area 12a, and is positioned highly accurately from the center of the receiving lens face 15 and the center of the transmitting lens face 16. The positioning section 13 is integrally molded with the base 10.

A production apparatus for connecting the photodiode 20 and the laser diode 50 to the conductive plates 30 may have a configuration in which the upper face of the base 10 is photographed with a camera or the like, the position of the positioning section 13 is used as a reference, and the photodiode 20 and the laser diode 50 are each connected at a position away from the positioning section 13 by a predetermined distance and a predetermined direction. With this configuration, the photodiode 20 can be connected to the first conductive plate 30a so that the center of the light-receiving section 22 of the photodiode 20 is nearly aligned with the center of the receiving lens face 15, and the laser diode 50 can be connected to the third conductive plate 30c so that the center of the light-emitting section 52 of the laser diode 50 is nearly aligned with the center of the transmitting lens face 16.

The base 10, the peripheral wall section 12, the positioning section 13, the receiving lens face 15, the transmitting lens face 16, the pillar section 17, etc. of the OSA 1 are integrally molded using a translucent synthetic resin. In other words, the base 10 serves as a holding section for holding the photodiode 20, the laser diode 50, the conductive plates 30, etc. and also serves as a base section on which the receiving lens face 15, the transmitting lens face 16, the pillar section 17, etc. are provided. For the production of the OSA 1, integral molding can be accomplished, for example, by the so-called injection molding as a method in which the conductive plates 30 formed into desired shapes in advance are disposed inside a metal mold and a transparent resin in a liquid form is poured and left to be cured. Since the photodiode 20 and the laser diode 50 are connected to the conductive plates 30 exposed to the base 10 after the integral molding of the synthetic resin is carried out, the synthetic resin constituting the base 10, the peripheral wall section 12, etc. can be selected regardless of the heat resistances of the photodiode 20 and the laser diode 50; hence, it is possible to select a synthetic resin having high molding accuracy and being hardly deformed under the influence of surrounding environment, such as temperature change.

Moreover, the OSA 1 is equipped with the cover 40 joined to the upper end of the peripheral wall section 12 provided on the upper face side of the base 10 to seal the concave area 12a. The cover 40 is formed into a plate shape having the same nearly rectangular shape as that of the base 10 in a plan view and is joined to the upper end of the peripheral wall section 12 by a method, such as ultrasonic welding or adhesion using adhesive. The cover 40 may be translucent or non-translucent and may be formed of the same material as that of the base 10, the peripheral wall section 12, etc. or may be formed of a material different from that thereof. When the cover 40 is joined, gas, such as nitrogen or dry air, may be sealed inside the concave area 12a, or the interior of the concave area 12a may be evacuated.

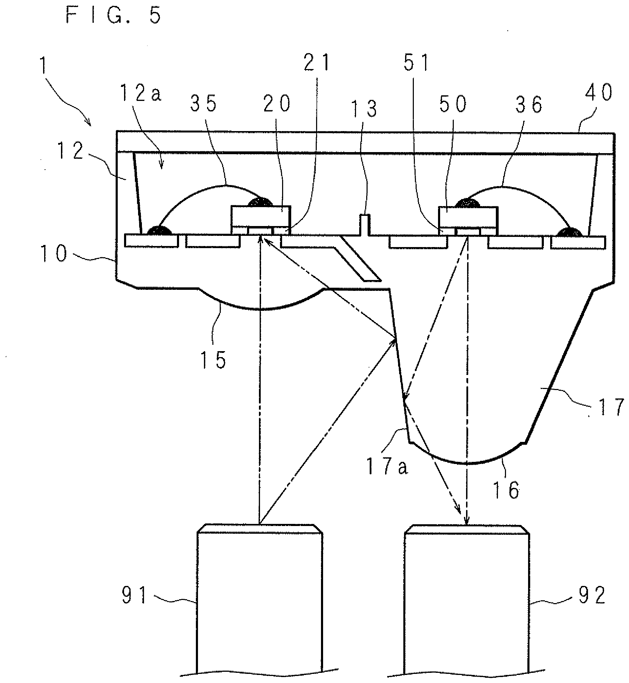

The OSA 1 according to the present invention is mounted on, for example, the circuit board of a communication apparatus and disposed so that the receiving lens face 15 and the transmitting lens face 16 are opposed to the end faces of a receiving optical fiber and a transmitting optical fiber. FIG. 5 is a schematic view showing a state in which the OSA 1 is disposed so as to be opposed to the two optical fibers. The OSA 1 shown in FIG. 5 is the same as the OSA 1 shown in FIG. 1, but some of the reference codes thereof are omitted.

A receiving optical fiber 91 and a transmitting optical fiber 92 are supported on, for example, the housing of a communication apparatus on which the OSA 1 is mounted; the end faces thereof are respectively opposed to the receiving lens face 15 and the transmitting lens face 16 of the OSA 1, and the positions of the end faces are aligned and secured. In the OSA 1 according to the present invention, the pillar section 17 is protruded from the lower face of the base 10 and the transmitting lens face 16 is formed at the protruded end of the pillar section 17, whereby the distance from the laser diode 50 to the transmitting lens face 16 is made longer than the distance from the photodiode 20 to the receiving lens face 15; in other words, the transmitting lens face 16 is provided at a position more protruded than that of the receiving lens face 15. Hence, the distance from the transmitting lens face 16 to the end face of the transmitting optical fiber 92 is shorter than the distance from the receiving lens face 15 to the end face of the receiving optical fiber 91.

The light (see a two-dot chain line arrow in FIG.5) from the receiving optical fiber 91 is incident on the receiving lens face 15 of the OSA 1 disposed so as to be opposed to an outgoing destination and is condensed to the light-receiving section 22 of the photodiode 20. However, a part of the light is outputted outside the receiving lens face 15, and further a part of the part is outputted to the side on which the pillar section 17 is provided. The light outputted to the side on which the pillar section 17 is provided reaches the flat face 17a formed on the pillar section 17 and is reflected to the receiving lens face 15 by the flat face 17a. At this time, the most part of the light having reached the flat face 17a from the receiving optical fiber 91 can be reflected by properly setting the refraction index of the translucent synthetic resin constituting the pillar section 17, the inclination angle of the flat face 17a formed on the pillar section 17 and the incident angle range (i.e., the disposition of the receiving optical fiber 91) of the light from the receiving optical fiber 91 to the flat face 17a, etc. A part of the light reflected by the flat face 17a is incident on the receiving lens face 15 and condensed to the light-receiving section 22 of the photodiode 20. The disposition between the optical fiber 91 and the transmitting lens face 16 is set in consideration of the widening range of the light outgoing from the receiving optical fiber 91 so that the most part of the light outgoing from the receiving optical fiber 91 is not directly incident on the transmitting lens face 16 (however, even in the case that a part of the light has reached the laser diode 50, no problem occurs because the light having reached the laser diode 50 is very weak and the laser diode 50 is less susceptible to the external light than the photodiode 20).

Furthermore, the light (see a one-dot chain line arrow in FIG.5) emitted from the light-emitting section 52 of the laser diode 50 passes through the pillar section 17 and reaches the transmitting lens face 16 and then is condensed to the transmitting optical fiber 92. However, a part of the light reaches the outside (i.e., the peripheral face of the pillar section 17) of the transmitting lens face 16, and further a part of the part reaches the flat face 17a of the pillar section 17. These parts of the light are totally reflected to the transmitting lens face 16 by the peripheral face and the flat face 17a of the pillar section 17 and condensed to the transmitting optical fiber 92 by the transmitting lens face 16. At this time, nearly the most of the light having reached the flat face 17a from the laser diode 50 can be reflected by properly setting the refraction index of the translucent synthetic resin constituting the pillar section 17, the inclination angle of the flat face 17a formed on the pillar section 17 and the incident angle range of the light from the laser diode 50 to the flat face 17a, etc. Hence, the light of the laser diode 50 is prevented from leaking to the side of the receiving lens face 15 and from being received by the photodiode 20.

For example, in the case that the incident angle of the light (the light most inclined with respect to the optical axis of the laser diode 50) outgoing from the laser diode 50 with respect to the flat face 17a is θ and the refraction index of the synthetic resin constituting the pillar section 17 is n, the light from the laser diode 50 can be prevented from leaking to the side of the receiving lens face 15 by setting the inclination angle of the flat face 17a so that the total reflection condition (sin θ = 1/n) is satisfied.

Since the OSA 1 configured as described above is equipped with the photodiode 20 for reception and the laser diode 50 for transmission and can carry out transmission and reception for optical communication using a single component, this configuration can contribute to making a communication apparatus incorporating the OSA 1 compact and low in cost, for example. Moreover, the distance between the receiving lens face 15 and the transmitting lens face 16 can be made short by integrally molding the base 10, the receiving lens face 15, the transmitting lens face 16, the pillar section 17, etc. using a translucent synthetic resin, whereby the OSA 1 can be made compact. Besides, light can be reflected by using the flat face 17a as a boundary by providing the transmitting lens face 16 at the protruded end of the pillar section 17 protruded from the base 10 and by forming the peripheral face of the pillar section 17 between the receiving lens face 15 and the transmitting lens face 16 into the flat face 17a, whereby light leakage from the transmission side to the reception side and from the reception side to the transmission side can be prevented. As a result, even in the case that the OSA 1 according to the present invention is made compact by narrowing the distance between the two lens faces, light leakage is prevented, whereby improper transmission and reception of optical signals can be prevented from occurring. Still further, since a part of the conductive plates 30 embedded inside the base 10 is formed into the light-shielding plate 32 and disposed between the transmission side and the reception side, light leakage between the transmission side and the reception side through the translucent base 10 can be prevented, whereby improper transmission and reception of optical signals can be prevented from occurring more securely.

The OSA 1 according to the embodiment is configured so as to be equipped with the two photoelectric devices, the photodiode 20 and the laser diode 50; however, without being limited to this, the OSA 1 may be configured so as to be equipped with three or more photoelectric devices. In this case, it is desired that the light-receiving device and the light-emitting device should be disposed alternately. Furthermore, the flat face 17a is formed on the peripheral face of the pillar section 17 between the receiving lens face 15 and the transmitting lens face 16; however, without being limited to this, another shape, such as a curved face, may be formed, provided that it can reflect light between the reception side and the transmission side; for example, the pillar section 17 may be formed into a frusto-conical shape not having the flat face 17a. Moreover, the photodiode 20 and the laser diode 50 are configured so as to have the light-receiving section 22 and the light-emitting section 52 on the lower faces thereof; however, without being limited to this, a configuration may be used in which the light-receiving section 22 and the light-emitting section 52 are provided on the upper faces thereof; in this case, for example, the receiving lens face 15, the transmitting lens face 16, the pillar section 17, etc. may be provided on the cover 40. Still further, the positioning of the photodiode 20 and the laser diode 50 is carried out using the positioning section 13 provided on the base 10; however, without being limited to this, the positioning may be carried out using other methods.

### (Modification example)

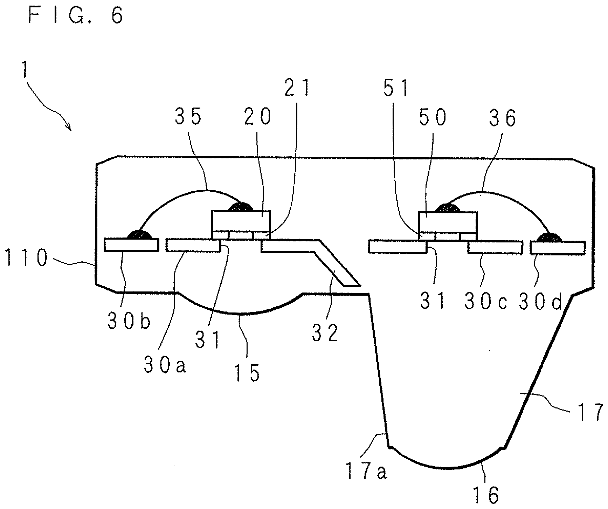

FIG. 6 is a schematic sectional view showing a configuration of an optical communication module according to a modification example of the present invention. The OSA 1 according to the above-mentioned embodiment 1 has a configuration in which the photodiode 20 and the laser diode 50 are accommodated inside the concave area 12a provided in the base 10 and the concave area 12a is sealed with the cover 40 so that the photodiode 20 and the laser diode 50 are sealed. On the other hand, the OSA 1 according to the modification example has a configuration in which the receiving lens face 15, the transmitting lens face 16, the pillar section 17, etc. are integrally formed into a sealing section 110 wherein the photodiode 20 and the laser diode 50 are sealed using a translucent synthetic resin. With this configuration, the production process of the OSA 1 can be simplified.

The resin sealing of the photodiode 20 and the laser diode 50 may be carried out separately from the integral molding of the receiving lens face 15, the transmitting lens face 16, the pillar section 17, etc. using a translucent synthetic resin. For example, the OSA 1 shown in FIG. 1 may be configured so that sealing is carried out by pouring a synthetic resin into the concave area 12a, instead of sealing the concave area 12a with the cover 40.
1 OSA (communication module)
10 base (holding section, base section)
12 peripheral wall section
12a concave area
13 positioning section
15 receiving lens face
16 transmitting lens face
17 pillar section
17a flat face
20 photodiode (light-receiving device)
21 connection terminal section
22 light-receiving section
30, 30a to 30d conductive plates
31 opening
32 light-shielding section
35, 36 wires
40 cover
50 laser diode (light-emitting device)
51 connection terminal section
52 light-emitting section
91, 92 optical fibers
110 sealing section

## Claims

1. An optical communication module comprising:
a light-emitting device (50) for converting an electric signal into an optical signal and for transmitting the optical signal,
a light-receiving device (20) for receiving an optical signal and for converting the optical signal into an electric signal,
a holding section (10) for holding the light-emitting device (50) and the light-receiving device(20) side by side,
a receiving lens face (15) and a transmitting lens face (16) integrally provided on a translucent base section (10) side by side,
a pillar section (17) integrally protruded from the base section (10) so that the transmitting lens face (16) is more protruded from the base section (10) than the receiving lens face (15) in the direction of the optical axis, and the transmitting lens face (16) is provided at the protruded end thereof,
wherein:
the light-receiving device (20) held on the holding section (10) receives an optical signal through the receiving lens face (15) and the base section (10), and the light-emitting device (50) held on the holding section (10) transmits an optical signal through the base section (10), the pillar section (17), and the transmitting lens face (16), and
a light-shielding section (32) is provided inside the base section (10) so that the outgoing path of an optical signal from the light-emitting device (50) is shut off from the incident path of an optical signal to the light-receiving device (20),
**characterized in that**:
each of the light-emitting device (50) and the light-receiving device (20) has a plurality of conductors (30, 30a-30d), and
the light-shielding section (32) is formed of a part of the conductors (30, 30a-30d).

2. An optical communication module according to claim 1, wherein the peripheral face (17a) of the pillar section (17) on the side of the receiving lens face (15) is formed into a flat face.

3. The optical communication module according to claim 1 or 2, wherein the base section (10) and the holding section (10) are integrally molded using a translucent synthetic resin.

## Patentansprüche

1. Optisches Kommunikationsmodul mit:
einer Lichtaussendevorrichtung (50) zum Umwandeln eines elektrischen Signals in ein optisches Signal und zum Übertragen des optischen Signals,
einer Lichtempfangsvorrichtung (20) zum Empfangen eines optischen Signals und zum Umwandeln des optischen Signals in ein elektrisches Signal,
einem Halteabschnitt (10) zum Halten der Lichtaussendevorrichtung (50) und der Lichtempfangsvorrichtung(20) nebeneinander,
einer Empfangslinsenfläche (15) und einer Übertragungslinsenfläche (16), die einstückig miteinander verbunden auf einem durchscheinenden Basisabschnitt (10) nebeneinander angeordnet sind,
einem Säulenabschnitt (17), der einteilig von dem Basisabschnitt (10) so vorragt, dass die Übertragungslinsenfläche (16) in Richtung der optischen Achse weiter von dem Basisabschnitt (10) vorragt als die Empfangslinsenfläche (15) und die Übertragungslinsenfläche (16) an seinem vorragenden Ende angeordnet ist,
wobei:
die auf dem Halteabschnitt (10) gehaltene Lichtempfangsvorrichtung (20) durch die Empfangslinsenfläche (15) und den Basisabschnitt (10) ein optisches Signal empfängt und die auf dem Halteabschnitt (10) gehaltene Lichtaussendevorrichtung (50) durch den Basisabschnitt (10), den Säulenabschnitt (17) und die Übertragungslinsenfläche (16) ein optisches Signal überträgt, und
ein Lichtabschirmungsabschnitt (32) in dem Basisabschnitt (10) so angeordnet ist, dass der ausgehende Pfad eines optischen Signals von der Lichtaussendevorrichtung (50) von dem eingehenden Pfad eines optischen Signals zu der Lichtempfangsvorrichtung (20) abgeschirmt ist,
**dadurch gekennzeichnet, dass**:
die Lichtaussendevorrichtung (50) und die Lichtempfangsvorrichtung (20) jeweils mehrere Leiter (30, 30a-30d) umfasst, und
der Lichtabschirmungsabschnitt (32) aus einem Teil der Leiter (30, 30a-30d) gebildet ist.

2. Optisches Kommunikationsmodul nach Anspruch 1, wobei
die Umfangsfläche (17a) des Säulenabschnitts (17) auf der Seiten der Empfangslinsenfläche (15) als flache Fläche ausgebildet ist.

3. Der optisches Kommunikationsmodul nach Anspruch 1 oder 2, wobei
der Basisabschnitt (10) und der Halteabschnitt (10) unter Verwendung eines durchscheinenden Kunstharzes einstückig geformt sind.

## Revendications

1. Module de communication optique comprenant :
un dispositif d'émission de lumière (50) destiné à convertir un signal électrique en un signal optique et à transmettre le signal optique,
un dispositif de réception de lumière (20) destiné à recevoir un signal optique et à convertir le signal optique en un signal électrique,
une section de maintien (10) afin de maintenir le dispositif d'émission de lumière (50) et le dispositif de réception de lumière (20) côte à côte,
une face de lentille de réception (15) et une face de lentille d'émission (16) agencées côte à côte de manière unitaire sur une section de base translucide (10),
une section formant colonne (17) s'étendant de manière unitaire à partir de la section de base (10) de telle sorte que la face de lentille d'émission (16) s'étend davantage à partir de la section de base (10) que la face de lentille de réception (15) suivant la direction de l'axe optique et la face de lentille d'émission (16) est agencée au niveau de l'extrémité étendue de celle-ci,
dans lequel :
le dispositif de réception de lumière (20) maintenu sur la section de maintien (10) reçoit un signal optique à travers la face de lentille de réception (15) et la section de base (10), et le dispositif d'émission de lumière (50) maintenu sur la section de maintien (10) émet un signal optique à travers la section de base (10), la section formant colonne (17) et la face de lentille d'émission (16), et
une section formant écran à la lumière (32) est agencée à l'intérieur de la section de base (10) de sorte que le trajet de sortie d'un signal optique à partir du dispositif d'émission de lumière (50) est séparé du trajet incident d'un signal optique vers le dispositif de réception de lumière (20),
**caractérisé en ce que** :
chacun du dispositif d'émission de lumière (50) et du dispositif de réception de lumière (20) comporte une pluralité de conducteurs (30, 30a à 30d), et
la section formant écran à la lumière (32) est formée d'une partie des conducteurs (30, 30a à 30d).

2. Module de communication optique selon la revendication 1, dans lequel
la face périphérique (17a) de la section formant colonne (17) sur le côté de la face de lentille de réception (15) est formée par une face plate.

3. Module de communication optique selon la revendication 1 ou 2, dans lequel
la section de base (10) et la section de maintien (10) sont moulées de manière unitaire en utilisant une résine synthétique translucide.
